# EUROPEAN PATENT APPLICATION

(11) **EP 3 358 518 A1**
(43) Date of publication of application: **08.08.2018**
(21) Application number: 16850760.6
(22) Date of filing: 20.06.2016
(51) Int. Cl.: G06Q 50/02

(54) **FARMWORK PLAN SUPPORT SYSTEM**

(30) Priority: 30.09.2015 JP 2015192546
(71) Applicant: Kubota Corporation, Osaka-shi, Osaka 556-8601 (JP)
(72) Inventor: ARAKI Hiroyuki, Amagasaki-shi Hyogo 661-0967 (JP); WATABE Yasushi, Amagasaki-shi Hyogo 661-0967 (JP); SAKAGUCHI Kazuo, Amagasaki-shi Hyogo 661-0967 (JP); AOTA Kazuki, Amagasaki-shi Hyogo 661-0967 (JP)
(74) Representative: Müller-Boré & Partner Patentanwälte PartG mbB
(86) International application number: PCT/JP2016/068228
(87) International publication number: WO 2017/056583

(57) **Abstract**

A farm work planning assistance system includes a field information storage section 6 configured to individually take in farm work information of fields of farming entities distributed over a wide area and to store the information as field information in combination with agro-environment information assigned to the respective fields, a farm work plan calculation section 7 configured to use, as an input parameter, farm work target information sent from each farming entity for a subject field as a subject for a farm work to be done by this farming entity and to extract farm work plan information for the subject field by referring to the field information, and an information output section 52 configured to output the extracted farm work plan information to the farming entity.

## Description

### TECHNICAL FIELD

This disclosure relates to a farm work planning assistance system configured to process information relating to farm works collected through use of a computer network and to provide information relating to an appropriate farm work plan.

### RELATED ART

An agricultural field management assisting system according to Patent Document 1 includes a field database for storing information relating to a location and a shape of an agricultural field on a map, a corrected growth index database for storing corrected growth index data, a work condition database for storing conditions for determining work contents based on a kind and a growth index of crops, and so on. Through use of such information stored in these databases, the system extracts information which forms basis for farm work determination such as the difference in distribution of growth in the field and visually displays such information. Then, a farmer will determine a farm work to be effected within the field based on the displayed information. The databases respectively have a multi-layered structure for each year, thus allowing past performance of the field to be utilized for a next farm work.

In a planting assisting apparatus according to Patent Document 2, based on respective field characteristics of a plurality of fields present in distribution on a map displayed on an image screen, a group of fields as planting candidates for a subject crop is retrieved from the plurality of fields and a combination of fields that satisfies a target yield of the subject crop is determined based on expected yields of the subject crop if planted in the respective fields. The determined fields will be shown on the map in a monitoring image screen in a special display mode different form the other fields. Then, a farm manager who is supposed to manage the plurality of fields will refer to the display image screen and will formulate a planting plan.

In a farming system according to Patent Document 3, contents of farm works carried out for each agricultural section such as rice planting, fertilization, harvesting, etc. are recorded together with respective costs thereof. Then, based on such performance data, a planning document of farm works to be done next is outputted.

### RELATED ART DOCUMENTS

### PATENT DOCUMENTS

Patent Document 1: Japanese Unexamined Patent Application Publication No. 2007-310463
Patent Document 2: Japanese Unexamined Patent Application Publication No. 2012-137819
Patent Document 3: Japanese Unexamined Patent Application Publication No. 2014-194653

### SUMMARY

### PROBLEM TO BE SOLVED BY INVENTION

Use of the respective computer systems relating to agriculture described above alleviates a burden on an agro-administrator who is to formulate a farm work plan, etc. relating to fields to be managed. In particular, in the case of the agricultural field management assisting system according to Patent Document 1, the field layers recording field data having field location information, information about a kind of crop to be cultivated, etc., and soil information are prepared for each year. With this, continuous evaluation using field relating information from the past to the present is made possible. So, an agro-administrator can make a farm work plan based on information on the field owned by this agro-administrator stored in accumulation for several past years.

However, such conventional systems collect only information about a plurality of fields of their own. Therefore, the information which forms the basis for field evaluation relates to the self-owned fields only. Namely, the amount of information to be used for e.g. statistical processing is rather limited. For this reason, there would occur shortage of information that is to form evaluation basis when it is desired to make a more developing and comprehensive farming management plan with reference to farm work information of a greater number of fields. Thus, there remains need for a system that assists making of a more appropriate farm work plan for management-subject fields by fully utilizing a processing ability of a computer capable of processing large amount of data, processing thereby nation-wide information relating to fields owned by other agro-administrators and making reference to such vast amount of field data.

### SOLUTION

For accomplishing the above-noted object, a farm work planning assistance system according to the present invention comprises:
a field information storage section configured to individually take in farm work information of fields of farming entities distributed over a wide area and to store the information as field information in combination with agro-environment information assigned to the respective fields;
a farm work plan calculation section configured to use, as an input parameter, farm work target information sent from each farming entity for a subject field as a subject for a farm work to be done by this farming entity and to extract farm work plan information for the subject field by referring to the field information; and
an information output section configured to output the extracted farm work plan information to said farming entity.

According to the above-described arrangement, farm work information of fields of respective farming entities that are present in distribution over a wide area are collected and stored as field information in the field information storage section. In this, the farm work information of the respective farming entity is combined with agro-environment information such as a weather condition, a soil condition, etc. which are important factors for a farm work to be done in that field. Even for farm work information relating to different regions, depending to the farm work data contained in such farm work information, farm work information of a field under a different agro-environment can be commonly used, with correction (normalization) thereof based on the agro-environment information. In addition, the working conditions of farm work machines included in farm work information, such as vehicle speed, work speed, etc., can be commonly used as they are because there are virtually little differences in the working conditions among regions. Each agro-administrator, when a farm work is to be done for a field of his/her own, will provide the farm work plan calculation section with farm work target information corresponding to the farm work to now be done. This farm work plan calculation section is configured to render the provided farm work target information for the farm work to be done into an input parameter and to extract farm work plan information from this input parameter. Thus, in response to input of the farm work target information thereto, the farm work plan calculation section will refer to the field information of fields including fields of other entities stored in the form described above and extract a farm work plan information of the subject field. Then, from the information output section, the agro-administrator can obtain a more appropriate farm work plan information.

Preferably, the farm work target information which constitutes an input parameter for extracting farm work plan information includes information that specifies the farm work in regard to when, where and about what the farm work to be done. Thus, according to a preferred embodiment of the present invention, the farm work target information contains the location of the subject field, farm work implementation timing, implemented crop species.

For farm work plan, the convention would implement statistical processing of information obtained from fields present within a small region having similar soil or climate and would utilize the result in making a future farm work plan. With rapid development of computer data processing, it has become possible to provide superior problem solution through utilization of data which has been unused so far. In particular, in the field of "Big Data" processing, superior solution has been made possible through use of data that has remained unused so far. Then, in order to take advantage of such computer processing technique of vast amount of data in a farm work planning, it is important that information of many fields be subjected to such processing. For this reason, according to one preferred embodiment of the present invention, the fields of the respective farming entities distributed over a wide area
include fields belonging to different owners distributed over various regions and the present farm work planning assistance system is applied to fields present in distribution nation-wide.

As farm works, there are basically required works in conformity with respective growth stages of the plant, such as, cultivating, seeding, growing, harvesting. Thus, a variety of farm work machines are used in farm works. Accordingly, it is important that the farm work information be collected through farm works by farm work machines used in correspondence with a respective growth stage of the farm crop. Then, according to one preferred embodiment of the present invention, the farm work information includes farm work data obtained through farm works by a plurality of kinds of farm work machines used in a same field.

In this invention, new farm work plan information is generated with reference to the farm work information of fields of respective farming entities present over a wide region. Thus, each farm work information as wide area information is generated as a comparison model body normalized as much as possible. Then, when a farm work plan suitable for a desired farm work in a desired field is requested, by referring to a comparison model body which is most similar to an input model body indicating the desired farm work in the desired field, it becomes possible to generate farm work plan information suited to such desired farm work in the desired field. For this reason, according to one preferred embodiment of the present invention, the field information includes farm work performance information which is performance of farm works implemented previously according to a farm work plan for each field; and the farm work plan calculation section generates an input model body based on each element of the farm work target information and generates a comparison model body group based on the field information extracted from the field information storage section and outputs the farm work plan information through comparison evaluation processing between the input model body and the comparison model body group.

More particularly, the farm work plan calculation section selects, from the comparison model body group, a comparison model body most similar to the input model body as a most similar model body and corrects the farm work plan information for the most similar model body based on a difference between the most similar model body and the input model body, thus outputting the farm work plan information. With this arrangement, it becomes possible to make a farm work plan in accurate maximal accordance with a superior farm work model.

### BRIEF DESCRIPTION OF THE DRAWINGS

[Fig. 1] is a diagram showing a basic configuration of a farm work planning assistance system,
[Fig. 2] is a functional configuration diagram of the farm work planning assistance system,
[Fig. 3] is an explanatory diagram of an input model body and comparison model bodies, and
[Fig. 4] is an explanatory diagram for explaining a most similar model body and farm work plan information through visualization thereof.

### EMBODIMENTS

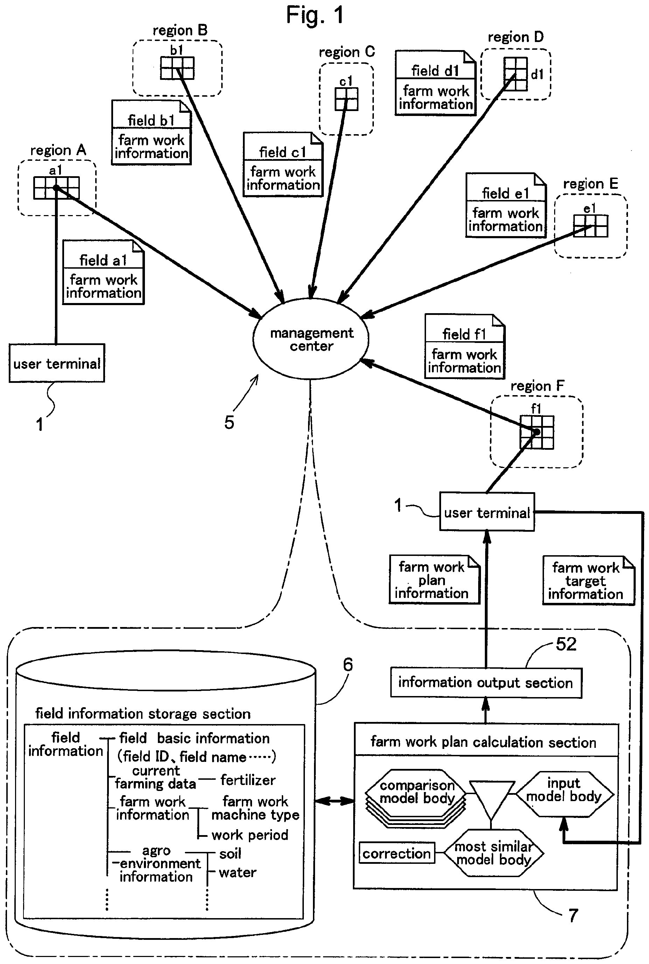

Prior to explanation of a configuration of a specific embodiment of a farm work planning assistance system according to the present invention, its basic configuration will be explained with reference to Fig. 1. The farm work planning assistance system is a computer network system utilizing the cloud computing technology. The farm work planning assistance system consists essentially of a user terminal 1 which can be a smart phone, a tablet, etc., and a computer system that manages large-scale database. The user terminal 1 and the computer system are connected to each other via the internet, a public network, etc. The user terminal 1 includes a data communication terminal such as a smart phone or a tablet carried by a farm worker, or a tablet terminal mounted to a farm work machine, etc. Since the computer system managing the database is installed in a management center 5, this computer system will be handled equivalent to a management center 5.

The user terminals 1 are used by farm workers working in fields (shown as fields a1 through f1 in Fig. 1) in a number of agricultural regions (shown as regions A-F in Fig. 1) distributed widely, for example nation-wide, or by farm work machines for effecting various works in such fields. Information relating to farm works to be done in each field is sent to the management center 5 via the respective user terminal 1 as farm work information added with an ID of that field ("field ID").

A field information storage section 6 serving as a database of the management center 5 stores field basic information of each registered field as one example of the field information. The field basic information includes the field ID, a field name, a field location (map location), a region, a field shape (contour), a field owner, a farm worker, etc. Other examples of the field information include present farm work data of each field, e.g. cultivated species, a cultivation history, a cultivation current situation, manuring history, manuring current situation, etc. The field information further includes agro-environment information. This agro-environment information includes e.g. a soil type, a soil condition, a water situation (water drainage, water retention, watering timing, etc.) of each field, a climate situation of a region in which the field belongs, and so on.

The farm work information sent from the user terminal 1 to the management center 5, in accordance with the information for identifying the field such as the added field name, field ID, will be incorporated into the field information of the field. The farm work information sent from the user terminal 1 of the farm worker includes a work date, a worker's name, work contents, a work period. In case the farm work information is collected by the user terminal 1 mounted on a farm work machine, the farm work information further includes a farm work machine type, a fuel consumption, farm work performance information thereof, and so on. The farm work performance information includes farm work machine operation data such as a traveling speed, a traveling course, etc. Moreover, the farm work machine operation data includes, as data unique to this farm work machine, e.g. a seedling planting amount in the case of a rice planter, a charged manure (fertilizer) amount in the case of a manuring machine, a yield, a food taste (gastronomic) value in the case of a combine. Such data contained in the farm work information and relating to a farm work are handled as farm work data.

For determination of an economic effect on each field, it is possible to record also farming information such as a cost, a sales per field in the field information. Moreover, a memo by a farm worker can be recorded also.

In the management center 5, there is configured a farm work plan calculation section 7 configured to use, as an input parameter, farm work target information sent from each farming entity via a smartphone, a personal computer or the like as the user terminal 1 of the farming entity for a subject field as a subject for a farm work to be done by this farming entity and to extract farm work plan information for the subject field. The farm work plan calculation section 7 extracts field information suited to the above farm work target information by referring to the field information recorded in the field information storage section 6 and relating to fields in the respective regions distributed nation-wide and then derives farm work plan information based on the extracted field information.

The farm work target information is information that corresponds to target farm work contents when a farming entity is to plan a farm work for its subject field. The farm work plan calculation section 7 firstly extracts, from the field information storage section 6, field information in fields for which a farm work similar to this farm work target information is being implemented, as "comparison model bodies". Further, from these comparison model bodies, the farm work plan calculation section 7 selects a "most similar model body" most similar to the farm work target information. From the field information constituting this most similar model body, the farm work plan calculation section 7 proceeds to extract farm work plan information, with making correction on the field information constituting the most similar model body when necessary. The farm work target information includes a field ID, an implemented crop species, an implemented period, an investible cost, etc. The farm work plan information includes a field ID, an implemented crops species, an implemented period, an investible cost, an individual farm work type (work type), an implemented period of each individual farm work, as well as a farm work machine type, a machine working period of farm work machine(s) for use in each individual farm work. etc. Needless to say, aside from the field ID which is an essential, specific items contained in the farm work target information can be selected as desired from any items stored in the field information storage section 6. Further, the information contained in the farm work plan information too can be arbitrarily selected items. The field ID of the subject field is essential for the farm work target information since this is needed for reading out field information including the location of the subject field and agro-environment information. Notwithstanding, if discrimination from the other fields is possible, then, such item as a field name can be used, instead of the field ID.

The farm work plan information extracted by the farm work plan calculation section 7 is visualized by an information output section 52 and presented as such to the farming entity through a printer output, a monitor output, etc.

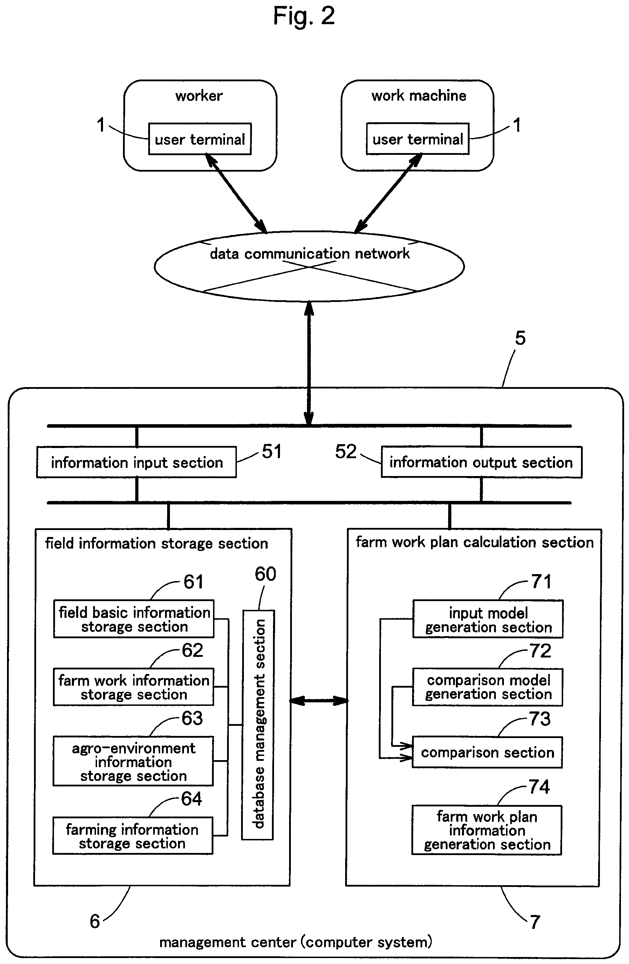

Next, specific arrangements of the farm work planning assistance system will be explained. As shown in Fig. 2, within the management center 5, there are formed functional sections as core components of the farm work planning assistance system. This management center 5 (computer system) includes, basically, an information input section 51, the field information storage section 6, the farm work plan calculation section 7, and the information output section 52. The information input section 51 forwards the information sent from the user terminal 1 into the system. The information output section 52 sends information generated from/within the system to the user terminal 1. When a farming entity makes a farm work plan, the information sent from the user terminal 1 via a data communication network is the farm work target information. Thus, based on this farm work target information, farm work plan information is generated and sent (returned) to the user terminal 1.

The field information storage section 6 is configured as a database and includes a database management section 60, a field basic information storage section 61 that stores the field basic information, a farm work information storage section 62 that stores the farm work information, an agro-environment information storage section 63 that stores agro-environment information, and a farming information storage section 64 that stores farming information. The database management section 60 has a function of storing the respective kinds of information in the field basic information storage section 61, the farm work information storage section 62, the agro-environment information storage section 63, and the farming information storage section 64 and extracting information that matches given retrieval conditions. The information stored in the field basic information storage section 61, the farm work information storage section 62, the agro-environment information storage section 63, and the farming information storage section 64 are linked to each other via one or more keywords. For instance, for a particular field specified by a field name or a field ID, the soil condition, the water situation, the climate situation, cultivation history, the manuring history, the yield history, the food taste history, etc. of that field can be linked.

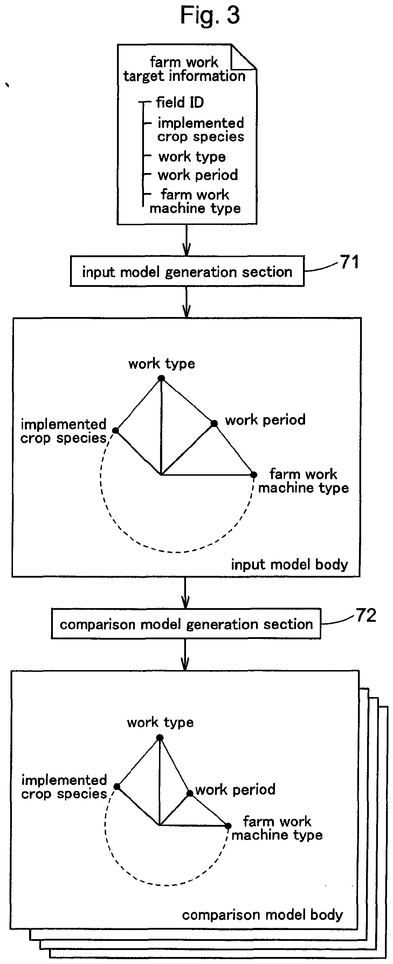

The farm work plan calculation section 7 includes an input model generation section 71, a comparison model generation section 72, a comparison section 73 and a farm work plan information generation section 74. The input model generation section 71 generates, from the farm work target information sent via the user terminal 1, input model bodies which are to form input parameters for use as retrieval conditions in the database management section 60. As schematically shown in Fig. 3, the farm work target information is information corresponding to a farm work desired to be implemented in the subject field, thus including a field ID, an implemented crop species, a work kind, an implemented period, a farm work machine type, etc. Thus, combination of these as retrieval keywords is to form the input model body mentioned above. Namely, this input model body is, in fact, a "compound retrieval keyword" to be used in the database management section 60. Then, the database management section 60 uses the input model body as a retrieval condition to extract field information having information items similar to this input model body. For evaluation of the extracted field information, the comparison model generation section 72 retrieves information items contained in the farm work target information from the extracted field information, thus generating one or more comparison model bodies similar to the input model body.

The comparison section 73 effects comparison evaluation between the input model body and the comparison model bodies and selects from the latter a comparison model body most similar to the input model body as a "most similar model body". Then, the farm work plan information generation section 74 generates farm work plan information based on the field information from which the most similar model body has been generated. This farm work plan information includes work contents, a work timing, a work period, a farm work machine type, etc. In this, if e.g. the field area (size) of the input model body (farm work target information) is found to be only a small fraction of that of the most similar model body, then, correction will be made such that the farm work plan information will designate a down-graded farm work machine type. Thus generated farm work plan information is sent via the information output section 52 to the user terminal 1 which sent the farm work target information mentioned above and on this user terminal 1, the information is visualized via a monitor display, print-out, etc. Then, with viewing the visualized farm work plan information, the farming entity will formulate an ultimate farm work plan.

Next, as a simple example of specific farm work plan, a manuring work for rice making will be explained. Here, there is shown a case in which a particular farming entity makes an access to the management center 5 and inputs thereto information relating a manuring work which identifies the work is for a field having a field ID: "1000" and for a rice cultivation of a rice species of "*...Hikari*" as farm work target information and then receives farm work plan information therefrom.

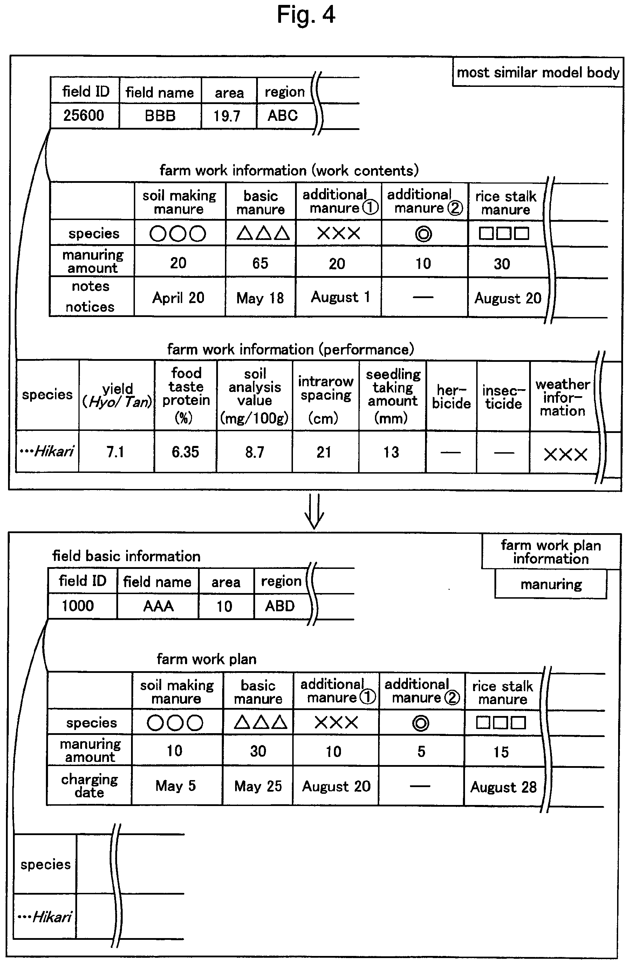

The farm work target information to be used as retrieval conditions for retrieving suited field information from the field information storage section 6 are: field ID: "25600", and farm work contents: "manuring work for rice making of rice species "... *Hikari*"*.* From the field ID: "25600" above, it is possible to read out such field basic information as the field name, the field area (size), field region as well as the agro-environment information of the field. Then, when a suited field information has been retrieved with using the input model body generated based on the farm work target information as the retrieval conditions, from this extracted field information, one or more comparison model bodies are generated. And, through comparison evaluation processing of the generated comparison model body (s) and the input model body, a most similar model body will be selected. Fig. 4 shows visualized information of such most similar model body in the form of a table.

Here, for this example of the visualized most similar model body, as the field basic information assigned to this field, there are included such items as "field ID", "field name", "area", "region", etc. Further, as the work contents contained in the farm work information of this field, there are included such items as "soil making manure", "basic manure", "additional manure 1", "additional manure 2", "rice stalk manure", etc. Further, as the performance information contained in the farm work information, there are included such items as "species", "yield", "food (rice) taste ("*shoku-mi*") (protein or moisture)", "soil analysis value", "intrarow spacing", "seedling taking amount", "herbicide", "insecticide", "weather information", etc.

Based on the contents of the most similar model body, there is generated farm work plan information indicating a manuring work in the subject field and the rice species " ... *Hikari*" and this information is sent to the corresponding user terminal 1. One example of such field basic information sent to the user terminal 1 and visualized is shown in Fig. 4. Here, there are shown the field basic information and a manuring work plan as a farm work plan. This manuring work plan is based on the manuring work contents of the most similar mode body, but a manuring amount etc. has been adjusted in consideration to a difference of field area and also a work date has been adjusted in consideration to a difference of agro-environment such as weather information.

As the field basic information, in addition to the fixed data such as a field name and a field location, e.g. a fertility degree of the field which changes for each year can also be stored in the field information storage section 6. In general, such fertility degree can be measured by using e.g. an electrical conductivity meter or the like. As a metering worker carrying the electrical conductivity meter measures fertility degree at a plurality of spots in the field, a fertility degree distribution of the field can be obtained. Further, it will be efficient if the electrical conductivity meter is mounted to a cultivation work machine such as a tractor for determining fertility degrees at the time of a cultivation work simultaneously.

Adjacent land information relating to a land (or a field) adjacent to the subject field can also be stored in the field information storage section 6 as the field basic information. This adjacent land information can be used as a limiting condition in obtaining the farm work plan information. For instance, if an organic farming is being implemented in the adjacent land, a selection, an amount etc. of fertilizer to be fed to the subject field as well as a manuring method will be taken into consideration.

In the process of selecting a most similar model body from comparison model bodies in the farm work plan calculation section 7, there can be provided a function of weighted calculation by applying weights to the respective data items constituting the comparison model bodies. And, if an arrangement is provided for allowing a user's operation of this weighting, then, based on this weighted calculation, farm work plan information with user's preference can be provided.

In case subject fields are present at a plurality of separate spots in distribution, the farm work plan calculation section 7 can take into consideration an order of farm works to be done for the respective subject fields, a traveling route for a farm work machine from one field to another, etc. Furthermore, vehicle dispatching plan for a farm work assisting vehicle such as a farm produce transport vehicle or a farming material supplying vehicle can also be included in the farm work plan. Examples of parameters for determining such vehicle dispatch plan include a quality of farm produce (high-quality produce will be given priority), a work period in each field (efficiency improvement of effective work hours per day), an operational condition of a drying facility in the case of crops harvest, species difference of harvested crops in the case of a harvesting work, an operational capacity such as a capacity of the farm work assisting vehicle, etc.

### [Other Embodiments]

(1) In the foregoing embodiment, there was employed the concept of input model body for retrieval of appropriate field information from the field information storage section 6. However, this input model body was used only for ready-to-understand explanation of the retrieval conditions consisting of a plurality of keywords. Instead, any other desired database retrieval method can be employed.
(2) The field information can be caused to contain a cost of a farm work machine used in a field. Such farm work machine cost incudes a work machine fuel cost, a work machine running cost, a work machine maintenance/inspection cost.
(3) In the foregoing embodiment, a most similar model body is determined and then farm work plan information generated based on this most similar model body is transmitted to a farming entity. Instead of this, a plurality of comparison model bodies having high similarities can be sent to the farming entity as the farm work plan information.
(4) In the foregoing embodiment, the management center 5 (computer system) was installed at one location only. Instead, such centers can be installed at a plurality of locations, so that each management center 5 can be accessed from a user terminal 1 for obtaining farm work plan information individually.

### INDUSTRIAL APPLICATION

The farming management system according to the present invention can be applied not only to a farm work such as rice making, a wheat making, but also as a work planning assistance system for a variety of farm works.

### Description of Reference Marks/Numerals

1: user terminal
5: management center (computer system)
51: information input section
52: information output section
6: field information storage section
60: database management section
61: field basic information storage section
62: farm work information storage section
63: agro-environment information storage section
64: farming information storage section
7: farm work plan calculation section
71: input model generation section
72: comparison model generation section
73: comparison section
74: farm work plan information generation section

## Claims

1. A farm work planning assistance system comprising:
a field information storage section configured to individually take in farm work information of fields of farming entities distributed over a wide area and to store the information as field information in combination with agro-environment information assigned to the respective fields;
a farm work plan calculation section configured to use, as an input parameter, farm work target information sent from each farming entity for a subject field as a subject for a farm work to be done by this farming entity and to extract farm work plan information for the subject field by referring to the field information; and
an information output section configured to output the extracted farm work plan information to said farming entity.

2. The farm work planning assistance system of claim 1, wherein the farm work target information contains the location of the subject field, farm work implementation timing, implemented crop species.

3. The farm work planning assistance system of claim 1 or 2, wherein the fields of the respective farming entities distributed over a wide area comprise fields belonging to different owners distributed over various regions.

4. The farm work planning assistance system of any one of claims 1-3, wherein the farm work information includes farm work data obtained through farm works by a plurality of kinds of farm work machines used in a same field.

5. The farm work planning assistance system of any one of clams 1-4, wherein:
the field information includes farm work performance information which is performance of farm works implemented previously according to a farm work plan for each field; and
the farm work plan calculation section generates an input model body based on each element of the farm work target information and generates a comparison model body group based on the field information extracted from the field information storage section and outputs the farm work plan information through comparison evaluation processing between the input model body and the comparison model body group.

6. The farm work planning assistance system of claim 5, wherein the farm work plan calculation section selects, from the comparison model body group, a comparison model body most similar to the input model body as a most similar model body and corrects the farm work plan information for the most similar model body based on a difference between the most similar model body and the input model body, thus outputting the farm work plan information.
